# EUROPEAN PATENT APPLICATION

(11) **EP 0 910 089 A2**
(43) Date of publication of application: **21.04.1999**
(21) Application number: 98301940.7
(22) Date of filing: 16.03.1998
(51) Int. Cl.: G11C 5/14

(54) **Storage circuit having backup function and information processing apparatus**

(30) Priority: 16.10.1997 JP 283852/97
(71) Applicant: FUJITSU LIMITED, Kawasaki-shi, Kanagawa 211-8588 (JP)
(72) Inventor: Kakimi, Toshiaki, c/o Fujitsu Limited,, Kawasaki-shi, Kanagawa 211-8588 (JP)
(74) Representative: Stebbing, Timothy Charles

(57) **Abstract**

A power supply unit (5) in an information processing apparatus detects a change in a power voltage, and a notification to that effect is transmitted to a storage circuit (1) to shift it to a backup state. It is desirable to construct the storage circuit (1) with simple configuration and more stable back up function. The storage circuit, to which while in a normal state a first power is supplied by a power supply unit and to which while in a backup state a second power is supplied, may include a storage unit (3) having a backup function for stored data; a voltage monitor circuit (4) for outputting a detection signal upon the detection of a drop in a voltage of the first power source to a predetermined voltage higher than a lowest voltage at which operation of the storage unit is available; and a controller (2) for supplying, upon receipt of a detection signal from the voltage monitor circuit, (4), the second power source to the storage unit (3) to perform the backup function. An information processing apparatus which incorporates such a storage circuit is also provided.

## Description

The present invention relates to an information processing apparatus, which comprises a storage unit constituted by a memory having a backup function and a controller for controlling the storage unit, and which can enable the storage unit to enter the backup state if the supply of power to the apparatus is halted, or if a blackout or an immediate power cutoff occurs.

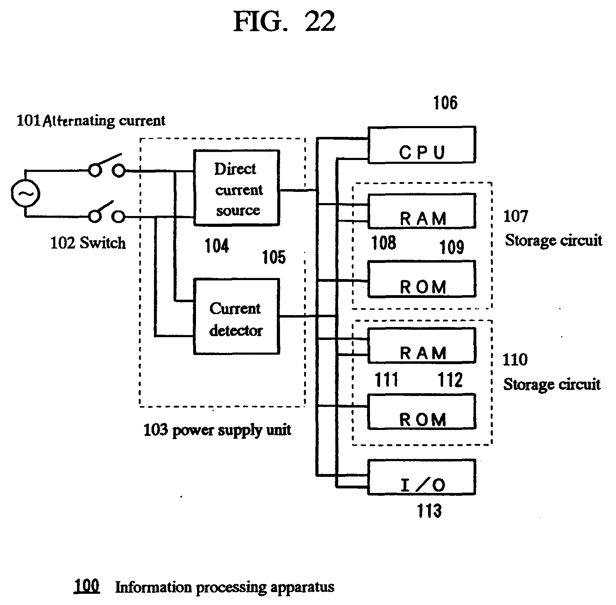

Fig. 22 is a diagram illustrating the arrangement of a conventional information processing apparatus 100. An alternating current 101 is supplied to a power supply unit 103 via a switch 102 and is converted into a direct current by a direct current power source 104. The direct current is then supplied to the individual circuits. A power detector 105 in the power supply unit 103 monitors the state of the alternating current 101. When there is an alternating current voltage drop, the power detector 105 transmits an appropriate signal to storage circuits 107 and 110 to prevent loss of data that are being processed.

ROMs 109 and 112 and RAMs 108 and 111 are employed for the memories of the respective storage circuits 107 and 110. When a blackout occurs during the operation of the information processing apparatus 100, data stored in the RAMs 108 and 111 are lost even though data stored in the ROMs 109 and 112 are not. Thus, when a blackout, etc., occurs, the direct current voltage supplied to the RAMs 108 and 111 must be switched to a direct current voltage supplied by a battery, in order for the loss of data to be prevented.

Conventionally, the power supply unit 103 of the information processing apparatus 100 detects changes in a current and exercises appropriate control of the storage circuits 107 and 110. That is, when the supply of power to the information processing apparatus 100 is halted, or when a change in the supplied alternating current 101 is detected, the power detector 105 of the power supply unit 103 notifies the storage circuits 107 and 110 that the supply of power has been halted, and shifts the RAMs 108 and 111 to the backup state.

When the supply of power is resumed, the power detector 105 of the power supply unit 103 notifies the storage circuits 107 and 110 that the power supply is unstable. Then, when the supply of power has become stabilized, the transmission of the notice is canceled. Upon the cancellation of the notice, the RAMs 108 and 111 are recovered from the backup state.

As is described above, conventionally, the storage circuits 107 and 110 perform initiation and termination of the data backup state in consonance with instructions received from the power supply unit 103. However, the following problems have arisen.
(1) Conventionally, the optimal arrangement was considered to involve the use of an alternating current input section to handle general power management, and for the alternating current 101 fed into the information processing apparatus 100 to be regarded as that which was to be monitored by the power supply unit 103. However, as a consequence of recent technical developments and the provision of more complicated arrangements of apparatuses, and the greater control accuracy provided thereby, it has become difficult to perform a rapid backup process that depends only on the general power management capability afforded by the alternating current input section.
(2) A second power supply unit 103 may be added in order to enhance the reliability of the information processing apparatus 100. When two power supply units 103 are employed, data backup need be initiated only when the supply of power is cut off to both units 103. However, the control method and the circuits employed for this arrangement are complicated.
(3) Since the power supply unit 103, which is a detection target, and the storage circuits 107 and 110, which are backup targets, are physically located at a distance from each other, an interface used for connecting them, and signal lines for the transmission of messages are required.
(4) Since a plurality of storage circuits 107 and 110 tend to be mounted in a large information processing apparatus 100, a plurality of the above interfaces must be prepared, so that the size of the circuit for implementing the backup function is increased.

In view of the above problems, an embodiment of the present invention may provide a storage circuit which can back up data at its discretion and does not need to wait for an instruction from a power supply unit, and an information processing apparatus employing such a storage circuit. Also, an embodiment of the present invention may provide a small, simple storage circuit that can accurately back up data, and an information processing apparatus therefor.

According to one aspect of the present invention, a storage circuit, to which while in a normal state a first power source is supplied by a power supply unit and to which while in a backup state a second power source is supplied, includes:
a storage unit having a backup function for stored data;
a voltage monitor circuit for outputting a detection signal upon the detection of a drop in a voltage of the first power source to a predetermined voltage higher than a lowest voltage at which operation of the storage unit is available; and
a controller for supplying, upon receipt of a detection signal from the voltage monitor circuit, the second power source to the storage unit to perform the backup function.

By using the present invention, the storage circuit can begin the backup of data on its own initiative, and need not wait for an instruction from the power supply unit. Further, since the direct current supplied to the storage circuit is monitored, the voltage monitoring circuit can be easily provided. And since interface and signal lines for connecting the power supply unit to the storage circuit are not required and the backup function can be accomplished by a small, simple circuit, the performance of the information processing apparatus employing this storage circuit can be improved.

In a storage circuit embodying the invention, the predetermined voltage is so set that the storage unit will have completed the backup before the voltage of the first power source has been reduced from the predetermined voltage to the lowest voltage.

In an embodiment of the invention, since the backup of the storage unit can be completed before a voltage to be supplied to the storage unit is reduced to the lowest voltage at which the storage unit can be operated, absolute protection is provided for the data stored in the storage unit.

In a storage circuit embodying the invention, when the storage unit is being accessed, based on a detection signal from the voltage monitoring circuit the controller permits the storage unit to initiate a data backup after the execution of an access has been completed.

By using the present invention, even if a blackout or an immediate power cutoff occurs during a memory access, the memory access is not halted and the backup of the storage unit is performed after the execution of the memory access has been completed. Thus, the data in the memory can be protected, and not damaged.

According to a second aspect of the invention, a storage circuit, to which in a normal state first and second power sources are supplied by a power supply unit, and to which during a backup operation a third power source is supplied, includes:
a storage unit, to which the first power source is supplied in a normal state, and which has a backup function for stored data;
a controller to which the second power source is supplied in a normal state; and
a voltage monitor circuit for outputting a detection signal upon detection of a drop in a voltage of the first power source to a first voltage higher than a lowest voltage at which an operation of the storage unit is available, or upon detection of a drop in a voltage of the second power source to a second voltage higher than a lowest voltage at which an operation of the controller is available,
   wherein, upon receipt of the detection signal from the voltage monitor circuit, the controller supplies the third power source to the storage unit to perform the backup function.

In an embodiment of this aspect, the two power voltage types can be monitored by a single voltage monitor circuit, and a backup function can be provided with a smaller circuit.

According to a third aspect of the invention, a storage circuit, to which in a normal state a first power source is supplied by a power supply unit, and to which a second power source is supplied in a backup state, includes:
a storage unit having a backup function for stored data;
a first voltage monitor circuit for outputting a first detection signal upon detection of a drop in a voltage of the first power source to a first voltage higher than a lowest voltage at which an operation of the storage unit is available;
a second voltage monitor circuit for outputting a second detection signal upon detection of a drop in a voltage of the first power source to a second voltage which is lower than the first voltage and higher than the lowest voltage; and
a controller for supplying, upon receipt of the first detection signal, the second power source to the storage unit to perform the backup function, and for resetting the controller upon receipt of the second detection signal.

In this aspect of the invention, since the controller is reset after the backup process by the storage unit has been completed, the data backup in the storage unit is ensured, and the erroneous operation of the controller, which may occur when there is a drop in a voltage supplied to the controller, can be prevented.

According to a fourth aspect of the invention, there is provided an information processing apparatus wherein a storage circuit, to which a power supply unit supplies a first power source in a normal state and a second power source in a backup state, is connected to an upper module via an interface, and the storage circuit includes:
a storage unit having a backup function for stored data;
a voltage monitor circuit for outputting a detection signal upon detection of a drop in a voltage of the first power source to a predetermined voltage higher than a lowest voltage at which an operation of the storage unit is available; and
a controller for supplying, upon receipt of the detection signal from the voltage monitor circuit, the second power source to the storage unit to perform the backup function, and for halting the backup function of the storage unit when the voltage of the first power source has been recovered and an operation start signal has been received from the upper module.

By means of this aspect, the backup state is not immediately released, even after the power voltage has been recovered, until the upper module has confirmed that the supply of a clock and the submission of an access request to the storage circuit can be performed normally, and has transmitted an operation start instruction. Therefore, improved operational safety can be provided.

An information processing apparatus embodying this aspect of the invention further includes backup notification means for notifying the upper module that the storage unit is in a backup state.

In this embodiment, since the upper module is notified that the storage unit is in the backup state, the upper module can more precisely monitor the backup state of the storage unit.

In the information processing apparatus of this embodiment, so long as a backup disable signal from the upper module is being received, the controller does not permit the storage unit to perform the backup operation, even when the detection signal has been received from the voltage monitoring circuit.

In the fourth aspect of the invention, even when the power voltage is reduced, instructions for whether or not the backup should be performed can be transmitted via the upper module. Therefore, a margin test can be easily conducted when the power voltage drops, and when a plurality of storage circuits are provided, individual storage circuits can be designated for the performance of the backup function.

Reference is made, by way of example, to the accompanying drawings, in which:-
Fig. 1 is a block diagram illustrating a storage circuit and a power supply unit according to one embodiment of the present invention;
Fig. 2 is a waveform diagram illustrating the change in a voltage of a power source in a normal state;
Fig. 3 is a timing chart for explaining the operation in Fig. 1;
Fig. 4 is a schematic diagram illustrating the arrangement of an information processing apparatus including a cache device;
Fig. 5 is a detailed circuit diagram showing a voltage monitoring circuit;
Fig. 6 is a timing chart for explaining the operation in Fig. 5;
Fig. 7 is a circuit diagram illustrating a storage circuit where a backup start signal extraction circuit is additionally provided;
Fig. 8 is a circuit diagram illustrating the backup start signal extraction circuit;
Fig. 9 is a timing chart for explaining the operation in Fig. 8;
Fig. 10 is a circuit diagram illustrating a storage circuit employing a reset signal when power is switched on;
Fig. 11 is a timing chart showing the reset signal and the backup start signal when power is switched on;
Fig. 12 is a block diagram illustrating a storage circuit for monitoring two types of power sources;
Fig. 13 is a detailed circuit diagram showing a voltage monitoring circuit for monitoring two types of power sources;
Fig. 14 is a block diagram for explaining a storage circuit including two voltage monitoring circuits;
Fig. 15 is a timing chart for explaining the operation of the backup and the reset voltage monitoring circuits;
Fig. 16 is a diagram illustrating a storage circuit when an operation start signal from the upper module is received and a backup state is released;
Fig. 17 is a circuit diagram illustrating a storage circuit including backup notification means;
Fig. 18 is a circuit diagram illustrating the backup notification means;
Fig. 19 is a timing chart for explaining the operation in Fig. 18;
Fig. 20 is a circuit diagram showing a storage circuit having a backup inhibition function;
Fig. 21 is a block diagram for explaining a separate backup function; and
Fig. 22 is a block diagram illustrating a conventional information processing apparatus.

The preferred embodiment of the present invention will now be described while referring to the accompanying drawings. However, the technical scope of the present invention is not limited to this embodiment.

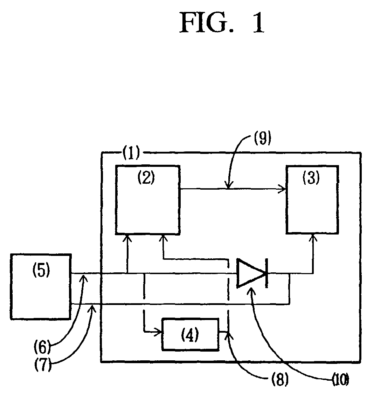

Fig. 1 is a block diagram illustrating a storage circuit 1 according to one embodiment of the present invention. The storage circuit 1 comprises a storage unit 3, constituted by a memory device having a backup function; a controller 2, for writing data to and reading data from the storage unit 3; and a voltage monitoring circuit 4, for monitoring changes in a power voltage supplied to the storage circuit 1.

A power supply unit 5 supplies, to the storage circuit 1, a power source 6 under normal conditions and a power source 7 during a backup. A backflow prevention diode 10 permits the backup power source 7 to flow only to the storage unit 3, and blocks a backflow to the normal power source 6.

The normal current 6 from the power supply unit 5 is supplied to the controller 2 and the voltage monitoring circuit 4, and, via the backflow diode 10, to the storage unit 3. The voltage monitoring circuit 4 monitors changes in the voltage of the normal current 6 supplied by the power supply unit 5. When the voltage drops, the voltage monitoring circuit 4 transmits a backup start signal 8 to the controller 2. Upon receipt of the backup start signal 8, the controller 2 transmits a memory control signal 9 to the storage unit 3, which is then set to the backup state.

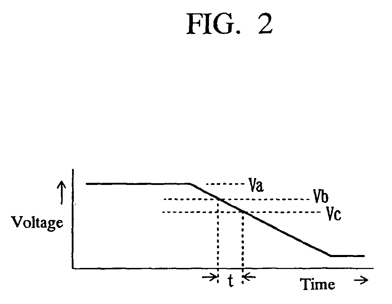

Fig. 2 is a waveform diagram showing a change in the voltage of the normal power source 6 supplied by the power supply unit 5. When, during the normal conditions, the power supply unit 5 halts for a specific reason the supply of power while the direct current voltage Va is being furnished, the voltage is reduced in accordance with a time constant produced by, for example, a capacitor connected to a power feeding line. That is, since various capacitors, such as a bypass capacitor for restricting voltage fluctuations and capacitors for supplying power to the individual components, are ordinarily connected along the power feeding line, the voltage does not immediately drop to zero when the supply of power is halted, but is reduced gradually over a specific period of time.

Normally, electronic components can be operated even when the power voltage falls to the operation limiting voltage (the lowest voltage at which operation of electronic components is possible) Vc, which is about 90% of the rated voltage Va. Assuming that the voltage is reduced to Vb, which is higher than Vc, the voltage monitoring circuit 4 detects that drop and transmits the backup start signal 8 to the controller 2.

Upon receipt of the backup start signal 8, the controller 2 transmits a memory control signal 9 to the storage unit 3, which is then set to the backup state. The backup for the storage unit 3 must be performed within time t, during which the power voltage is reduced from Vb to Vc. While such a voltage reduction usually takes several milliseconds of time t, the backup control for the memory requires only several hundreds of nanoseconds, so there is an adequate period of time available for the performance of the backup process.

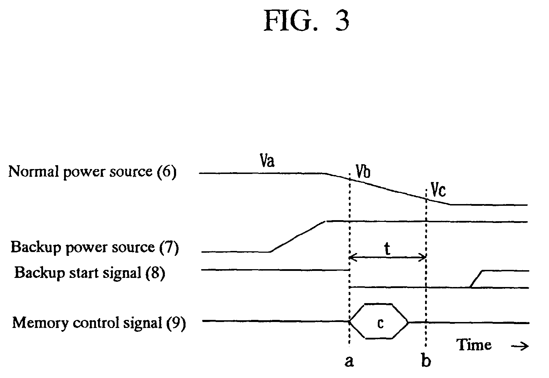

Fig. 3 is a timing chart for explaining the operation in Fig. 1. When the power supply unit 5 detects a condition which indicates the supply of power to the apparatus is to be halted, it starts the supply of the backup power source 7 and halts the supply of the normal power source 6. The voltage of the normal power source 6 is gradually reduced thereafter as described above.

The voltage monitoring circuit 4 detects the voltage of the normal power source 6 when it reaches the specified value Vb (point a in Fig. 3), and transmits the backup start signal 8 for level L to the controller 2. Upon receipt of the backup start signal 8, the controller 2 transmits the memory control signal (signal c in Fig. 3) to the storage unit 2, which is then set to the backup state.

During this period, as is described above, the process performed by the controller 2 to set the storage unit 3 to the backup state must be completed before the normal power source 6 is reduced to the operation limiting voltage Vc (point b in Fig. 3).

When the voltage for the normal power source 6 is 5 V, while assuming that the voltage Vb is 4.7 V and Vc is 4.5 V and that the voltage is reduced linearly from 5 V to 0 V over a period of time lasting 100 ms, it is found by a calculation employing these values that the time required for the voltage to be reduced from Vb to Vc is 4 ms. And since the time required for setting the storage unit 3 to the backup state is several hundreds of ns when using current, typical dynamic RAM, adequate time is available in which to perform the backup. Since the time required to reduce the power voltage from 5 V to 0 V is determined to be about 200 ms, when measured by a conventional device, adequate performance of the above backup process is possible.

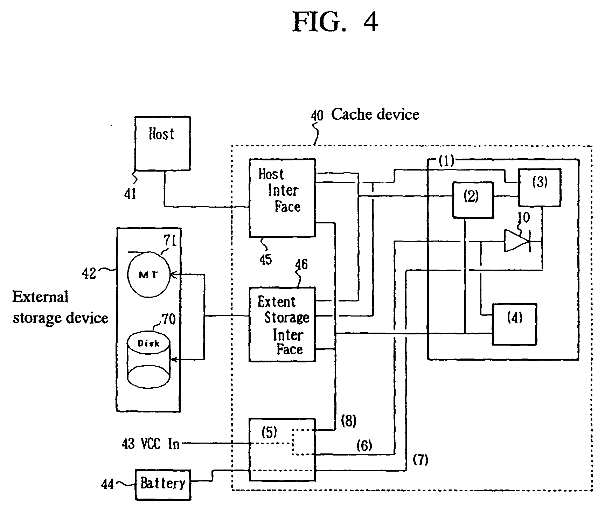

Fig. 4 is a schematic diagram illustrating the arrangement for this embodiment of an information processing apparatus incorporating a cache device 40. A host interface 45 is employed by a host (a large computer) 41 to access the cache device 40, and an external interface 46 is employed to exchange data with an external storage device 42 including a magnetic disk 70 and a magnetic tape 71. Although only one storage circuit 1 is shown in Fig. 4, a plurality of storage circuits 1 having the same connection configuration may be provided. Further, while the cache device 40 is accessed by only one host 41 in Fig. 4, a common external storage device 42 may be accessed via a plurality of channels by a plurality of controllers.

The power supply unit 5 distributes a direct current supplied from an external power source (VCC In) 43 to the individual circuits as normal power sources 6 and 8. The power supply unit 5 also supplies a current fed from a backup power source (battery) 44 to the storage unit 3 as the backup power source 7.

Data the host 41 requires are stored on the magnetic disk 70 or on the magnetic tape 71 in the external storage device 42. Upon receipt of the request for data from the host 41, the data are read from the external storage device 42 and are transmitted to the host 41.

When the data read from the external storage device 42 are recorded in the storage circuit 1, upon receipt of the same request from the host 41 they must be read from the storage circuit 1, rather than from the external storage device 42, and transmitted to the host 41.

Since data can be read from the storage circuit 1 much faster than from the external storage device 42, the overall performance of the information processing apparatus can be improved. Similarly, data are written only to the storage circuit 1, and the actual writing of data to the magnetic disk 70 is performed later, in an extra period of time.

When data stored in the storage circuit 1 are lost due to the momentary cutoff of a current, the data must be read from the external storage device 42 upon the receipt of a request for the data from the host 41, and the performance of the information processing apparatus is thereby degraded. Further, since data are written only to the storage circuit 1, the loss of data is equivalent to the destruction of data and results in a deterioration of reliability.

With the arrangement employing the present invention, even when a problem associated with the supply of power of the storage circuit 1 occurs, as the protection of data has the highest priority, the loss of data can be prevented. Even when circuits other than the storage circuit 1 are unaware of the sudden cutoff of power, means is provided for notifying the host 41 that the storage circuit 1 is in the backup state, as will be described later, so that a process for the recovery of power and for the release of the backup state can be performed and the correct reading of data can be continued.

Fig. 4 is a diagram illustrating an information processing apparatus incorporating a cache device when the storage circuit 1 is to be backed up. The present invention can be applied to another arrangement that provides for data held in a memory to be backed up. For example, since when a semiconductor disk device, a replacement for a magnetic disk device, is employed and all the data are stored in a semiconductor memory, the effect due to the destruction or loss of data will be greater, the present invention can also be applied to the backup of data stored in the semiconductor device.

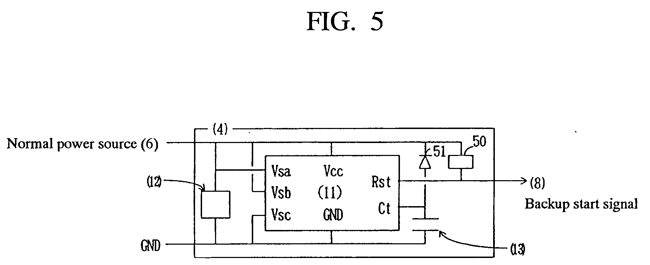

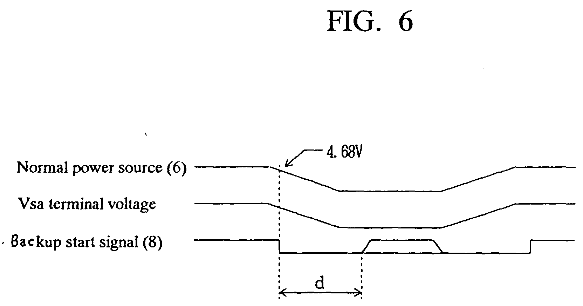

Fig. 5 is a detailed circuit diagram illustrating the voltage monitoring circuit 4 in the storage circuit 1 according to the embodiment. Fig. 6 is a timing chart for explaining the operation of the voltage monitoring circuit 4. In this embodiment, a voltage monitor device 11 (MB3771, produced by Fujitsu) is employed for the voltage monitoring circuit 4 for monitoring the normal power source 6 of 5 V.

The terminals Vcc, Vsa and Vsb of the voltage monitoring device 11 are connected to the normal power source 6, and the terminals Vsc and GND are connected to the GND line. A resistor 12 is connected between the terminal Vsa and the GND line, and a capacitor 13 is connected between the terminal Ct and the GND line. A diode 51 is connected between the terminals Vcc and Ct, and a resistor 50 is connected between the terminals Vcc and Rst.

When the voltage for the normal power source 6 (the voltage at the terminal Vsa), which is an input voltage, is reduced to a specific value or lower, the voltage monitoring circuit 4 outputs from the terminal Rst a signal of level L. With the value of the resistor 12 in Fig. 5 as 360 kΩ, when the voltage of the normal power source 6 reaches 4.68 V, the output of the terminal Rst goes to level L. The time period (d in Fig. 6) for the maintenance of the L-level output at the terminal Rst is determined by the electrostatic capacitance of the capacitor 13.

The output at the terminal Rst is transmitted as the backup start signal 8 to the controller 2. When the backup start signal 8 goes to level L, the controller 2 initiates the control process for setting the storage unit 3 to the backup state.

The voltage monitoring circuit 4 not only outputs a signal at level L from the terminal Rst when the supply of the normal power source 6 is halted, as is shown in Fig. 6, but also when the supply of power is begun. Therefore, when the supply of the normal power source 6 is begun, a countermeasure is required for the controller 2 to inhibit the performance of the backup function by the storage unit 3.

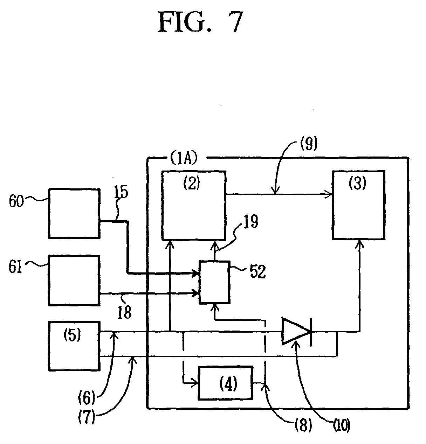

In Fig. 7 is shown a storage circuit 1A for which is additionally provided an extraction circuit 52 for extracting only a backup start signal when the supply of power is halted. The backup start signal extraction circuit 52 receives a clock signal 15 from a clock generator 60 and a reset signal 18 from a power-on reset circuit 61, and extracts a signal, from the backup start signal 8, for output to the controller 2 only when the supply of power is halted.

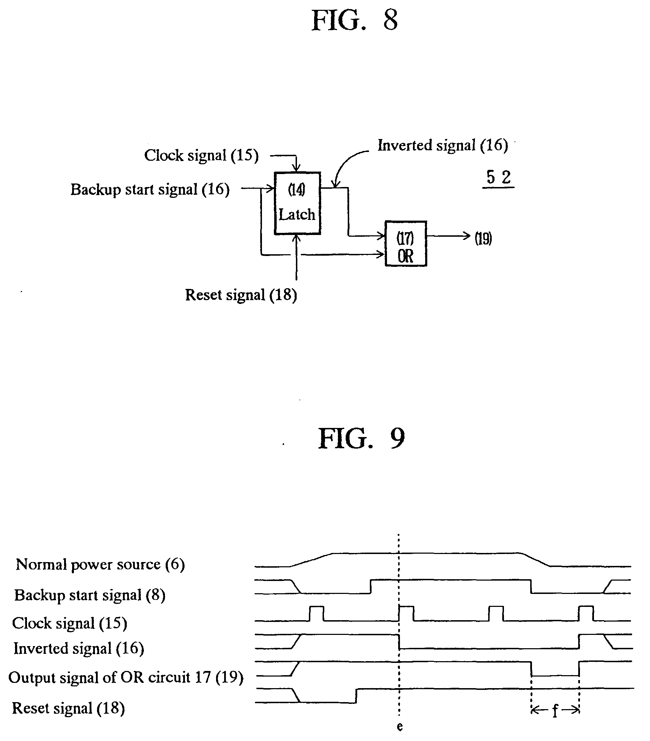

Fig. 8 is a circuit diagram showing the backup start signal extraction circuit 52, and Fig. 9 is a timing chart for explaining the operation of the extraction circuit 52. The backup start signal extraction circuit 52 comprises a latch circuit 14 and an OR circuit 17. The latch circuit 14 receives the backup start signal 8 from the voltage monitoring circuit 4, the clock signal 15 from the clock generator 60, and the reset signal 18 from the reset circuit 61. The OR circuit 17 receives an inversion signal 16 from the latch circuit 14 and the backup start signal 8.

The backup start signal extraction circuit 52 is provided at the input stage of the controller 2, and of the signals which are generated when the supply of power is initiated and when it is halted, extracts only the backup start signal 8 generated when the power of supply is halted.

When the supply of the normal power source 6 is begun and the voltage is gradually raised, as is shown in Fig. 9, the backup start signal 8 goes to level L, as was previously mentioned. The latch circuit 14 is reset upon receipt of the reset signal 18 generated when the supply of power is resumed, and the inversion signal 16 goes to level H. Following this, when the time determined by the electrostatic capacitance of the capacitor 13 in Fig. 5 has elapsed, the backup start signal 8 goes to level H. When the reset signal 18 goes to level H, the reset state of the latch circuit 14 is released. At the leading edge of the clock signal 15 at time e in Fig. 9, the inversion signal 16 is driven down to level L.

The OR circuit 17 drives the output signal 19 to level L only when two input signals are at level L. That is, when either input signal is at level H, the output signal 19 goes to level H. As for the output signal 19 of the OR circuit 17, since the inversion signal 16, one of the input signals, is maintained at level H until point e is reached, and the backup start signal 8, the other input signal, goes to level H after the point e is reached, the level L of the backup start signal 8 when the supply of power is begun is canceled.

When the supply of the normal current 6 is halted and the voltage is gradually reduced, the backup start signal 8 again goes to level L. Since the inversion signal 16 and the backup start signal 8, which are input signals for the OR circuit 17, go to level L during the period f in Fig. 9, the output signal 19 of the OR circuit 17 goes to level L. The controller 2 employs the level L of the output signal 19 of the OR circuit 17 as the original backup start signal to initiate a control process for setting the storage unit 3 to the backup state.

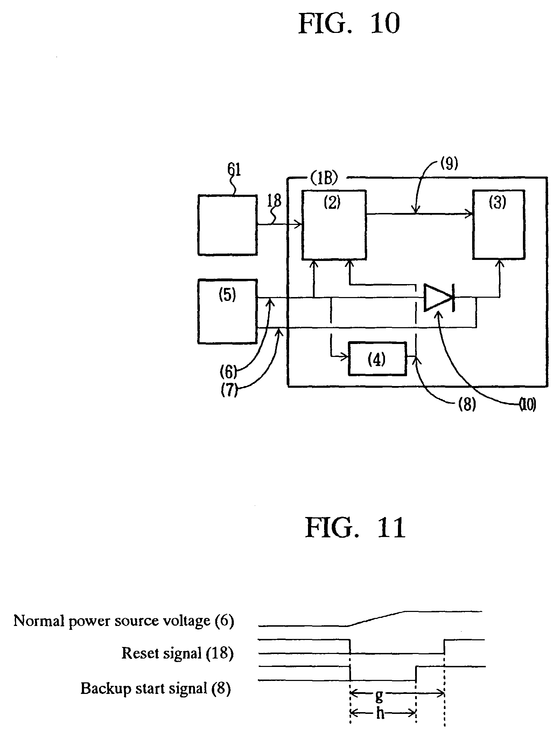

Fig. 10 is a diagram illustrating a storage circuit 1B which employs a reset signal to invalidate a backup start signal 8 when power is switched on, and Fig. 11 is a timing chart for this operation. The controller 2 of the storage circuit 1B in Fig. 10 receives a reset signal 18 from a power-on reset circuit 61. This method can be used when the reset signal 18 when power is on is established for an extended period of time.

As is shown in Fig. 11, the reset signal 18 output by the power-on reset circuit 61 is set at level L during period g. The electrostatic capacitance of a capacitor 13 connected to the voltage monitor device 11 in Fig. 5 is so determined that a period h in which the backup start signal 8 is set at level L is shorter than the period g. As a result, even if the backup start signal 8 goes to level L when the supply of the normal current 6 is begun, the controller 2 is still reset and can ignore the signal 8.

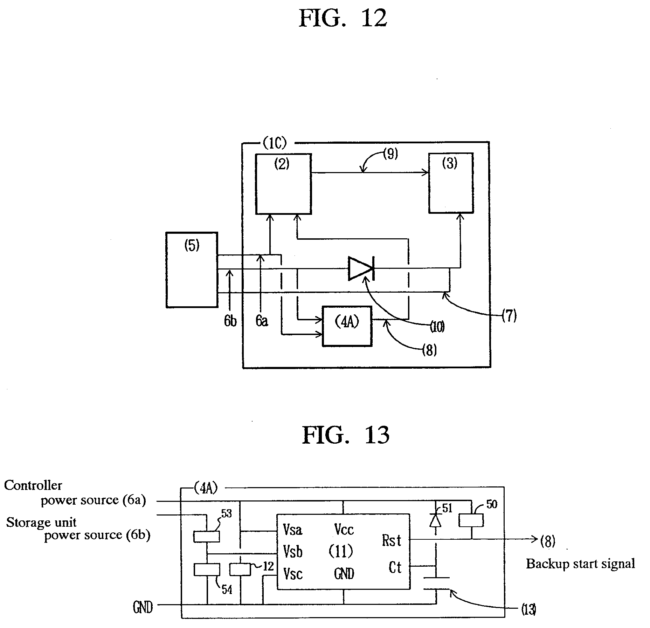

Fig. 12 is a diagram showing a storage circuit 1C having a voltage monitoring circuit 4A which monitors two types of power sources. When the power sources for the controller 2 and for the storage unit 3 in Fig. 1 differ, if, for example, a power source of 5 V is used for the controller 2 and a power source of 3.3 V is used for the storage unit 3, the voltages of both power sources must be monitored. In this case, while the voltage monitoring circuit 4 may be provided for the individual monitoring of the power source for the controller 2 and the power source for the storage unit 3, the circuit in Fig. 12 employs only one voltage monitoring circuit 4A to monitor the voltages of the two power sources.

Fig. 13 is a diagram showing a detailed circuit of the voltage monitoring circuit 4A, which may monitor the voltages of two power sources in the embodiment of the storage circuit 1C according to the present invention. The structure of Fig. 13 is similar to that of Fig. 5, but in Fig. 13, there is provided a resister 53 between the power source 6b and a terminal Vsb, and a resister 54 between the terminal Vsb and the ground line GND, so that a power source 6a for the controller 2 and a power source 6b for the storage unit 3 are monitored.

In an example circuit in Fig. 13, the voltage of a power source 6a for the controller 2 is monitored at terminal Vsa of the voltage monitor device 11, and the voltage of a power source 6b for the storage unit 3 is monitored at terminal Vsb. Assuming that 5 in is supplied by the power source 6a and 3.3 in is supplied by the power source 6b and the resistance at a resistor 12 is 360 KΩ, the resistance at a resistor 53 is 1.8 KΩ and the resistance at a resistor 54 is 1.2 KΩ. When the voltage for the power source 6a drops to 4.68 V, or the voltage for the power source 6b drops to 3.1 V, the backup start signal is driven to level L.

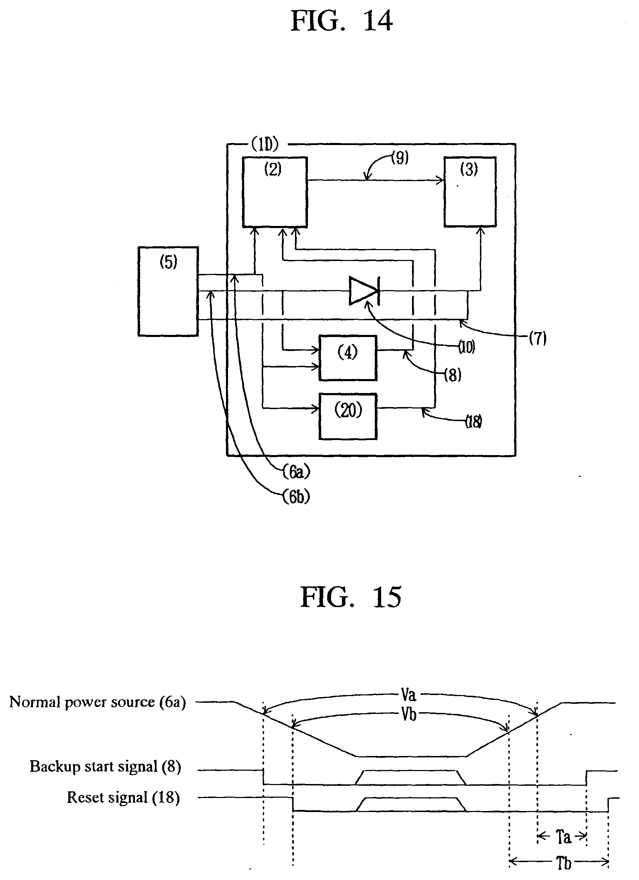

Fig. 14 is a diagram showing two voltage monitoring circuits 4 and 20 provided in a storage circuit 1D according to the embodiment of the present invention, and Fig. 15 is a timing chart. In this example, for an active insertion/removal procedure, the storage circuit 1D incorporates the voltage monitoring circuit 20 for resetting the controller 2, in addition to the voltage monitoring circuit 4 for backing up the storage unit 3.

In the example circuit in Fig. 14, the reset signal 18 from the power-on reset circuit 61 in Fig. 10 is not employed as a reset signal for the controller 2, but instead, the voltage monitoring circuit 20 generates such a reset signal while monitoring the voltage of the normal power source 6a.

A power supply unit 5 in Fig. 14, as well as the one in Fig. 12, outputs as a normal power source, a power source 6a for the controller 2 and a power source 6b for the storage unit 3. The circuit shown in Fig. 13 is used as the voltage monitoring circuit 4 and monitors the power sources 6a and 6b. The voltage monitoring circuit 20 monitors the power source 6a and transmits a reset signal 18 to the controller 2.

In this case, the time required for backing up the storage unit 3 and the time required for beginning to reset the controller 2 must be taken into account. When the supply of power is halted, first, the backup process for the storage unit 3 must be performed, and then the controller 2 must be reset. To perform the processes in this order, only the voltages detected by the voltage monitoring circuits 4 and 20 need differ.

Specifically, as is shown in Fig. 15, when the voltage of the normal power source 6a falls to Va, the voltage monitoring circuit 4 transmits the backup start signal 8, and the voltage monitoring circuit 20 transmits the reset signal 18 at a voltage Vb, lower than the voltage Va. It should be noted that the time required for the voltage of the normal power source 6a to be reduced from Va to Vb is so set that it is longer than the time required to back up the storage unit 3.

When the supply of power from the normal power source 6a is begun, first, the backup start signal 8 and the reset signal 18 simultaneously go to level L. Then, the reset signal 18 goes to level L when time Tb, which is determined by the electrostatic capacitance of the capacitor provided for the voltage monitoring circuit 20, has elapsed following the time at which the voltage for the normal power source 6a became Vb. The backup start signal 8 goes to level H when time Ta, which is determined by the electrostatic capacitance of the capacitor provided for the voltage monitoring circuit 4, has elapsed following the time at which the voltage for the normal power source 6a became Va.

When the electrostatic capacitance of the capacitor in the voltage monitoring circuit 20 is set considerably higher than is that of the capacitor used in the voltage monitoring circuit 4, and the time Tb is longer than the time Ta, as previously described, the backup start signal 8, which is generated when power is switched on, can be ignored by using the reset signal 18.

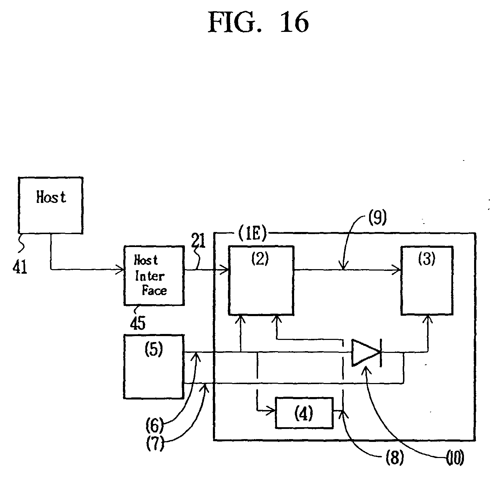

In Fig. 16 is shown a storage circuit 1E, which receives a signal 21 for permitting the upper module (Host) 41 to start an operation and release the backup state. When the apparatus is powered on, the supply of power from a normal power source 6a is established. Under a condition where no backup start signal 8 is transmitted, the controller 2 may, as it determines, transmit a memory control signal to the storage unit 3 to release the backup state of the storage unit 3. However, it is safer, before releasing the backup state of the storage unit 3, to confirm that the supply of a clock and a request for access to the storage circuit 1E can be normally performed.

Therefore, the controller 2 waits to receive the operation start permission signal 21 from the upper module 41 via a host interface 45. When the operation start permission signal 21 is received by the controller 2, under the condition where power is stably supplied and no backup start signal 8 has been transmitted, the controller 2 transmits the memory control signal 9 to the storage unit 3 to release the backup state.

Furthermore, when, during the operation of the apparatus, a disturbance causes the voltage of the normal power source 6 to fluctuate, it is probable that the voltage monitoring circuit 4 will detect that functional irregularity and transmit the backup start signal 8 to set the storage unit 3 to the backup state. It also is probable that, when power is turned on, the transmission of the backup start signal 8 will not be halted for a specific cause, and will be continued even after the supply of power is stabilized.

To cope with these cases, a means is required which can notify the upper module 41 that the storage unit 3 is in the backup state, and which can release the backup state upon the receipt of an operation start permission signal from the upper module.

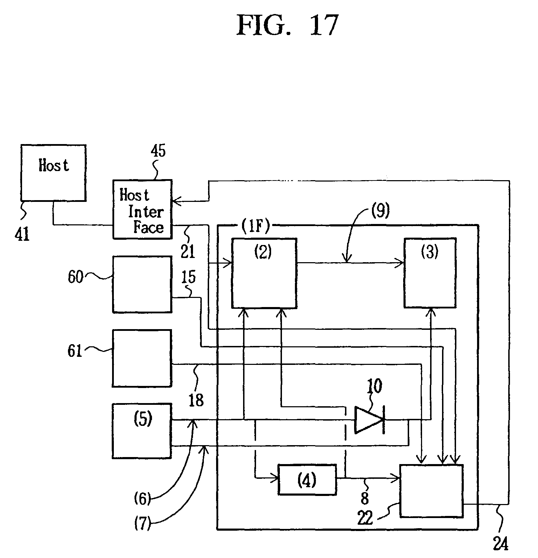

In Fig. 17 is shown a storage circuit IF incorporating backup notification means 22. The backup notification means 22 receives an operation start signal 21 from an upper module 41 via a host interface 45, a clock signal 15 from a clock generator 60, a reset signal 18 from a power-on reset circuit 61, and a backup start signal 8 from a voltage monitoring circuit 4. The backup notification means 22, in turn, outputs a backup notification signal 24 via the host interface 45 to the upper module 41.

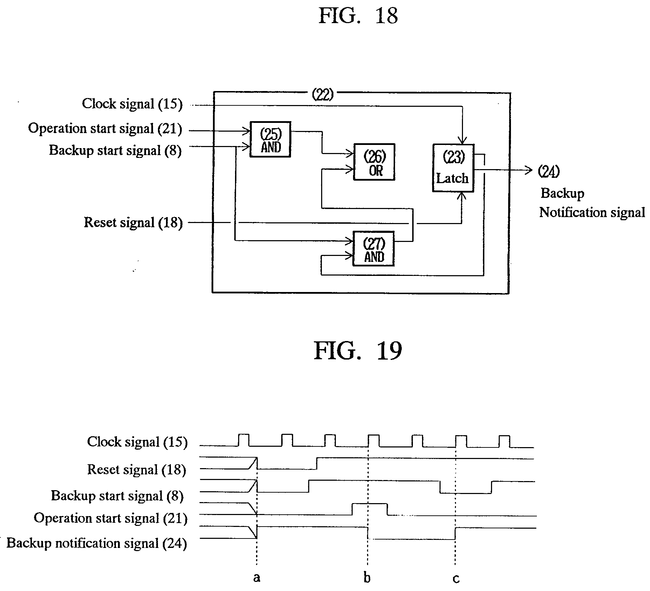

Fig. 18 is a circuit diagram showing the backup notification means 22, and Fig. 19 is a timing chart. As is shown in fig. 18, the backup notification means 22 comprises AND circuits 25 and 27, an OR circuit 26, and a latch circuit 23. The AND circuit 25 receives the operation start permission signal 21 from the upper module 41 and the backup start signal 8 from the voltage monitoring circuit 4, while the latch circuit 23 receives the clock signal 15 and the reset signal 18, which is output when the power is switched on.

The latch circuit 23, like a D-flip flop, is operated in synchronization with the leading edge of the clock signal 15, and is initialised upon the receipt of the reset signal 18. The latch circuit 23 outputs a positive logic version of the fetched signal to the AND circuit 27, and outputs an inverted logic signal version as a backup notification signal 24. The backup notification signal 24 serves as a signal for, in response to the output of the operation start signal 21 by the upper module 41, notifying the upper module 41 that the storage unit 3 is in the backup state.

As is shown in Fig. 19, the backup notification signal 24 is raised to level H in response to the reset signal 18 when the apparatus is powered on (point a in Fig. 19), and the upper module 41 is notified that the storage unit 3 is still in the backup state. Then, the supply of power is stabilized, the transmission of the reset signal 18 and the backup start signal 8 is halted, and the operation start permission signal 21 is transmitted by the upper module 41. At this time, since both input terminals of the AND circuit 25 are at level H, a signal output by the AND circuit 25 also goes to level H and is fetched via the OR circuit 26 by the latch circuit 23. Thus, the backup notification signal 24 goes to level L (point b in Fig. 19), and the upper module 41 is notified that the backup state of the storage unit 3 has been released.

The positive logic signal, which is the other signal output by the latch circuit 23, is fed back via the AND circuit 27 and the OR circuit 26, so that the signal fetched by the latch circuit 23 is held.

Following this, when the voltage monitoring circuit 4 detects that the voltage of the normal power source 6 has been reduced for a specific cause and transmits the backup start signal 8, one of signals received by the AND circuit 27 goes to level L. Accordingly, the signal output by the AND circuit 27 goes to level L, and is fetched by the latch circuit 23 via the OR circuit 26. As a result, the backup notification signal 24 goes to level H (point c in Fig. 19), and the upper module 41 is notified that the storage unit 3 has been set to the backup state.

As previously described, although the electronic components can be operated at a voltage of 90% of the rated voltage, there may be some components which can not be operated at a low voltage because of differences in their characteristics. In order to prove that the employed electronic components can even be operated at 90% of the rated voltage, a voltage margin test must be conducted to confirm the operation at a voltage which is 85% of the rated voltage. Therefore, in order to operate the storage circuit normally at 85% of the rated voltage, a function for inhibiting the output of a backup start signal 8 by the voltage monitoring circuit 4 or a function for permitting the controller 2 to ignore the signal 8 even though it has been output is requested during the voltage margin test.

In addition, it is possible for only one storage circuit to be backed up in an apparatus in which a plurality of the above described storage circuits are mounted. In this case also, a function is required which inhibits the operation of the voltage monitoring circuit 4 for the storage circuits which are not to be backed up.

As a countermeasure, a switch which can be set arbitrarily, or a like mechanism, may be provided. According to the simplest method, a signal for inhibiting a backup is sent from the switch, and the backup start signal 8 is masked by the input stage of the controller 2. Then, even when the voltage monitoring circuit 4 is activated and transmits the backup start signal 8, the signal 8 is ignored and the backup process for the storage unit 3 is not performed.

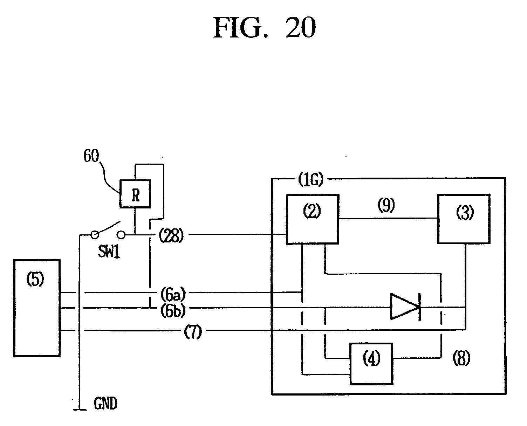

Fig. 20 is a block diagram for explaining a storage circuit 1G having a function for inhibiting a backup according to the embodiment. A controller 2 in the storage circuit 1G can inhibit the backup operation for the storage unit 3 even when there is a power voltage drop upon the receipt of a backup disable signal 28.

The storage circuit 1G receives normal power source currents 6a and 6b from a power supply unit 5 and a backup power source current 7. A switch SW1 is used to transmit the backup disable signal 28 to the controller 2 in the storage circuit 1G, and a resistor 60 is a pull-up resistor for raising the backup disable signal 28 to level H during a normal operation.

In Fig. 20, the ON/OFF state of the switch SW1 is used to instruct whether or not the storage circuit 1G is to be backed up. When the controller 2 receives the backup start signal 8 while the backup disable signal 28 is at level H, the controller 2 initiates the control to set the storage unit 3 to the backup state.

When the switch SW1 is OFF, the voltage of the power source current 6a or 6b, supplied by the power supply unit S, is reduced, and a voltage monitoring circuit 4 detects the reduction and transmits the backup start signal 8. Since the backup disable signal 28 is at level H, the controller 2 transmits a memory control signal 9 for setting the storage unit 3 to the backup state.

When the switch SW1 is ON, the controller 2 does not transmit a memory control signal 9 for setting the storage unit 3 to the backup state because the backup disable' signal 28 is at level L. As is described above, whether or not the storage circuits 1G is to be backed up can be instructed by using the ON/OFF state of the switch SW1.

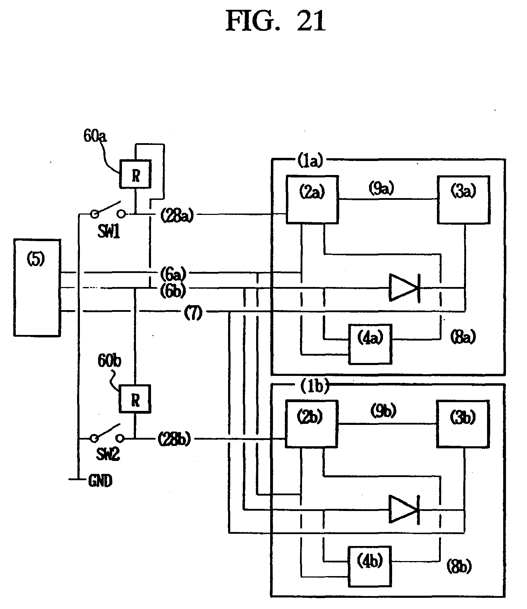

Fig. 21 is a block diagram for explaining the function for separately backing up storage circuits 1a and 1b according to the embodiment. The storage circuits 1a and 1b receive the normal power sources 6 and 6b by a power supply unit 5, and the backup power source 7. A switch SW1 is used to transmit a backup disable signal 28a to a controller 2a in the storage circuit 1a, and a switch SW2 is used to transmit a backup disable signal 28b to a controller 2b in the storage circuit 1b. Resistors 60a and 60b are pull-up resistors for raising the backup disable signals 28a and 28b in the normal condition.

In Fig. 21, whether the storage circuit 1a or 1b is to be backed up is instructed by turning on or off the switches SW1 and SW2. When the switch SW1 is OFF and the switch SW2 is ON, the voltage of the normal power source 6a or 6b, supplied by the power supply unit 5, is reduced, and a voltage monitoring circuit 4a or 4b detects that reduction and transmits a backup start signal 8a or 8b.

Since the backup disable signal 28a is at level H, the controller 2a transmits a memory control signal 9a for setting the storage unit 3a to the backup state. On the other hand, since the backup disable signal 28b is at level L, the controller 2b does not transmit a memory control signal 9b for setting the storage unit 3b to the backup state.

In the above described manner, while the storage circuit 1a is backed up, the storage circuit 1b is not backed up. In other words, an instruction for a backup can be issued to the individual storage circuits by using the switches SW1 and SW2. Although in Figs. 20 and 21 the switch SW1 and the other components are provided outside the storage circuit, all components may be incorporated in the storage circuit.

In addition, the switch SW1 and may be provided along a line for the backup power source 7, and whether or not the backup power source 7 may be selected by the ON/OFF states of the individual switches. In this case, the controller 2 would set the storage unit 3 to the backup state, regardless of the switch state. However, since the backup power source 7 is not supplied to the storage circuit when the switch is OFF, the backup operation would not be performed. The above described switch may be replaced with a relay which is turned on or off upon the receipt of an instruction signal from a software program or a management module.

When the apparatus is to be powered off, the backup of data is initiated. During a memory access of the storage unit 3, a blackout or sudden power cutoff, or a power voltage fluctuation in the apparatus, may occur. When the controller 2 receives the backup start signal 8 during a memory access and immediately halts the memory access process, the data stored in the memory may be destroyed.

In the storage circuit according to the embodiment of the present invention, when the controller 2 receives the backup start signal 8 during a memory access, the controller 2 continues the memory access process and does not perform a backup process for the storage unit 3 until the memory access process is completed.

Even when the length of a time required for a memory access is long, such as that for a burst memory access (a method for sequentially writing or reading data in response to an access command), the total time required for the memory access and the backup start process is only several µs. This period of time is sufficiently long compared with several ms, which is the time required for the voltage to reach the operation limiting voltage following the detection of the drop in the voltage.

As is described above, according to a storage circuit or an information processing apparatus embodying the present invention, even when the supply of power is halted, or when a blackout or a momentary power cutoff occurs, at its discretion the storage circuit can set the storage unit to the backup state, so as to protect data. Further, a function required in association with this operation can be implemented at the same time.

Since an information processing apparatus can be constructed by using a small, simple circuit, an apparatus having a simple design and a guaranteed operation can be provided and its performance can be enhanced.

The present invention may be embodied in other specific forms without departing from the essential characteristics thereof. The present embodiment is therefore to be considered in all respects as illustrative and not restrictive, the scope of the invention being indicated by the appended claims rather than by the foregoing description and all changes which come within the meaning and range of equivalency of the claims are therefore intended to be embraced therein.

## Claims

1. A storage circuit, to which while in a normal state a first power source is supplied by a power supply unit and to which while in a backup state a second power source is supplied, comprising:
a storage unit having a backup function for stored data;
a voltage monitor circuit for outputting a detection signal upon the detection of a drop in a voltage of said first power source to a predetermined voltage higher than a lowest voltage at which operation of said storage unit is available; and
a controller for supplying, upon receipt of the detection signal from said voltage monitor circuit, said second power source to said storage unit to perform said backup function.

2. The storage circuit according to claim 1, wherein said predetermined voltage is so set that said storage unit will have completed the backup before the voltage of said first power source has been reduced from said predetermined voltage to said lowest voltage.

3. The storage circuit according to claim 1 or 2, wherein, when said storage unit is being accessed, based on a detection signal from said voltage monitoring circuit, said controller permits said storage unit to initiate a data backup after the execution of an access has been completed.

4. A storage circuit, to which in a normal state a first power source is supplied by a power supply unit and in a backup state a second power source is supplied, comprising:
a storage unit having a backup function for stored data;
a voltage monitoring circuit for outputting a first detection signal upon detection of a drop in a voltage of said first power source to a predetermined voltage higher than a lowest voltage at which operation of said storage unit is available, and for outputting a second detection signal upon detection of an increase in a voltage of said first power source from a voltage lower than said predetermined voltage to said predetermined voltage;
an extraction circuit for extracting said first detection signal from said first and said second detection signals output by said voltage monitoring circuit; and
a controller for supplying, upon receipt of a signal from said extraction circuit when extracting said first detection signal, said second power source to said storage unit to perform said backup function.

5. A storage circuit, to which in a normal state a first power source is supplied by a power supply unit and to which in a backup state a second power source is supplied, comprising:
a storage unit having a backup function for stored data;
a voltage monitoring circuit for outputting a first detection signal upon detection of a drop in a voltage of said first power source to a predetermined voltage higher than a lowest voltage at which operation of said storage unit is available, and for outputting a second detection signal upon detection of an increase in a voltage-of said first power source from a voltage lower than said predetermined voltage to said predetermined voltage; and
a controller for supplying, upon receipt of a first detection signal from said voltage monitoring circuit, said second power source to said storage unit to perform said backup function, and for shifting to a reset state upon receipt of said detection signal.

6. A storage circuit, to which in a normal state a first and a second power sources are supplied by a power supply unit, and to which during a backup operation a third current is supplied, comprising:
a storage unit, to which said first power source is supplied in a normal state, and which has a backup function for stored data;
a controller to which said second power source is supplied in a normal state; and
a voltage monitor circuit for outputting a detection signal upon detection of a drop in a voltage of said first power source to a first voltage higher than a lowest voltage at which an operation of said storage unit is available, or upon detection of a drop in a voltage of said second power source to a second voltage higher than a lowest voltage at which an operation of said controller is available,
wherein, upon receipt of said detection signal from said voltage monitor circuit, said controller supplies said third power source to said storage unit to perform said backup function.

7. A storage circuit, to which in a normal state a first power source is supplied by a power supply unit, and to which a second power source is supplied in a backup state, comprising:
a storage unit having a backup function for stored data;
a first voltage monitor circuit for outputting a first detection signal upon detection of a drop in a voltage of said first power source to a first voltage higher than a lowest voltage at which an operation of said storage unit is available;
a second voltage monitor circuit for outputting a second detection signal upon detection of a drop in a voltage of said first power source to a second voltage which is lower than said first voltage and higher than said lowest voltage; and
a controller for supplying, upon receipt of said first detection signal, said second power source to said storage unit to perform said backup function, and for resetting said controller upon receipt of said second detection signal.

8. An information processing apparatus wherein a storage circuit, to which a power supply unit supplies a first power source in a normal state and a second power source in a backup state, is connected to an upper module via an interface, said storage circuit comprising:
a storage unit having a backup function for stored data;
a voltage monitor circuit for outputting a detection signal upon detection of a drop in a voltage of said first power source to a predetermined voltage higher than a lowest voltage at which an operation of said storage unit is available; and
a controller for supplying, upon receipt of said detection signal from said voltage monitor circuit, said second power source to said storage unit to perform said backup function, and for halting said backup function of said storage unit when said voltage of said first poewr source has been recovered and an operation start signal has been received from said upper module.

9. The information processing apparatus according to claim 8, further comprising:
backup notification means for notifying said upper module that said storage unit is in a backup state.

10. The information processing apparatus according to claim 8 or 9, wherein, so long as a backup disable signal from said upper module is being received, said controller does not permit said storage unit to perform said backup operation, even when said detection signal has been received from said voltage monitoring circuit.
